# EUROPEAN PATENT SPECIFICATION

(11) **EP 0 418 984 B1**
(45) Date of publication and mention of the grant of the patent: **14.07.1993**
(21) Application number: 90202501.4
(22) Date of filing: 20.09.1990
(51) Int. Cl.: H01L 31/052, H01L 31/0236

(54) **A semiconducting photo element and a method of manufacturing same**
Halbleiter-Photobauelement und Herstellungsverfahren
Dispositif photoélectrique à semiconducteur et méthode de fabrication

(30) Priority: 21.09.1989 NL 8902371
(43) Date of publication of application: 27.03.1991
(73) Proprietor: INTERUNIVERSITAIR MICROELEKTRONICA CENTRUM VZW, 3030 Leuven-Heverlee (BE)
(72) Inventor: Nijs, Johan Francis Albert, B-3202 Linden-Lubbeek (BE); Demesmaeker, Els Suzanne Josefa, B-1760 Roosdaal (BE)
(74) Representative: Land, Addick Adrianus Gosling

(56) References cited:
- EP-A- 0 071 396
- US-A- 4 608 451
- THE CONFERENCE RECORD OF THE 18TH IEEE PHOTO-VOLTAIC SPECIALISTS CONFERNCE, Las Vegas, 21st - 25th October 1985, pages 192-197, IEEE, New York, US; M.G. MAUK et al.: "Thin silicon solar cells with internal reflection and their fabrication by solution growth"
- THE CONFERENCE RECORD OF THE 19TH IEEE PHOTOVOLTAIC SPECIALISTS CONFERENCE-1987, New Orleans, 4th - 8th May 1987, pages 392-397, IEEE, New York, US; M.G. MAUK et al.: "Demonstration of optical enhancement in solution-grown thin-film silicon solar cells"
- PROCEEDINGS OF THE 9TH E.C. PHOTOVOLTAIC SOLAR ENERGY CONFERENCE, Freiburg, 25th - 29th September 1989, pages 317-319, Kluwer Academic Publishers, Dordrecht, NL; E. DEMESMAEKER et al.: "Wafer bonding for thin film silicon solar cells with optical confinement"

## Description

In order to achieve high outputs from solar cells, the converting layers of these solar cells should be thin - see EP-A-0071396. Incident radiation on such converting layers should be confined in this converting layer -see also EP-A-0071396.

According to EP-A-0071396 the converting layer of a solar cell is deposited onto a reflecting diffraction grating showing a square wave arrangement.

From the Conference Record of the 18th IEEE Photovoltaic Specialists Conference, Las Vegas, 21-25 October 1985, pages 192-197, it is known to grow an epitaxial layer onto a textured layer of SiO₂ to improve confinement of the incident light.

The present invention provides a method for producing a semiconductor element for converting incident light into charge carriers, comprising the steps of:
- providing a semiconductor substrate with hollows;
- providing a converting part of semiconductor material for converting incident light into charge carriers; and
- bonding the substrate and the converting part together, such that cavities with air inclusions are formed.

According to a preferred embodiment of the present invention a wafer of high quality of semiconducting material can be bonded to the substrate and thinned to the required thickness, such that a thin converting layer with high quality results.

Further, the present invention provides an element of semiconductor material comprising:
- a substrate of doped semiconductor material; a converting layer for converting incident light into charged carriers; and
- a reflecting interface between the substrate and said converting layer; **characterised in that**
- the interface comprises cavities with air inclusions, whereby a large difference in the index of refraction between the converting layer and the substrate results.

It is noted that the method according to the present invention provides an elegantly simple way of forming a thin converting layer on a thicker substrate, creating a reflecting surface in between. Either a converting layer having the required thickness is applied to the substrate, or the converting layer is thinned after it has been bonded onto the substrate, e.g. by means of etching.

Further advantages, features and details of the present invention will become apparent in the light of a description of a preferred embodiment thereof with reference to a drawing, wherein:
fig. 1 shows a schematic cross sectional view of a preferred embodiment of the semiconducting photo element according to the present invention; and
fig. 2A and 2B show respective diagrams for explaining the preferred embodiment of the method according to the present invention.

A p+ substrate is provided with a conducting contact 1 and provided with cavities or hollows 3, 3' for forming of a reflecting structure between the substrate 2 and a converting layer 4 to be applied thereto wherein incident radiation designated schematically with R has to be converted into (minority) charge carriers.

The structure 5 is completed by a passivating layer 6 preferably provided with texturization to enable easy connection of the light and electrical contacts 7, 7' in addition to an anti-reflective layer 8 as generally known in the prior art. The P+-layer has for instance a resistivity of approximately 0.03 Ωcm, and the P--converting layer for instance 2 Ωcm. The surface layer resistance amounts for example to 40-200 Ω/□.

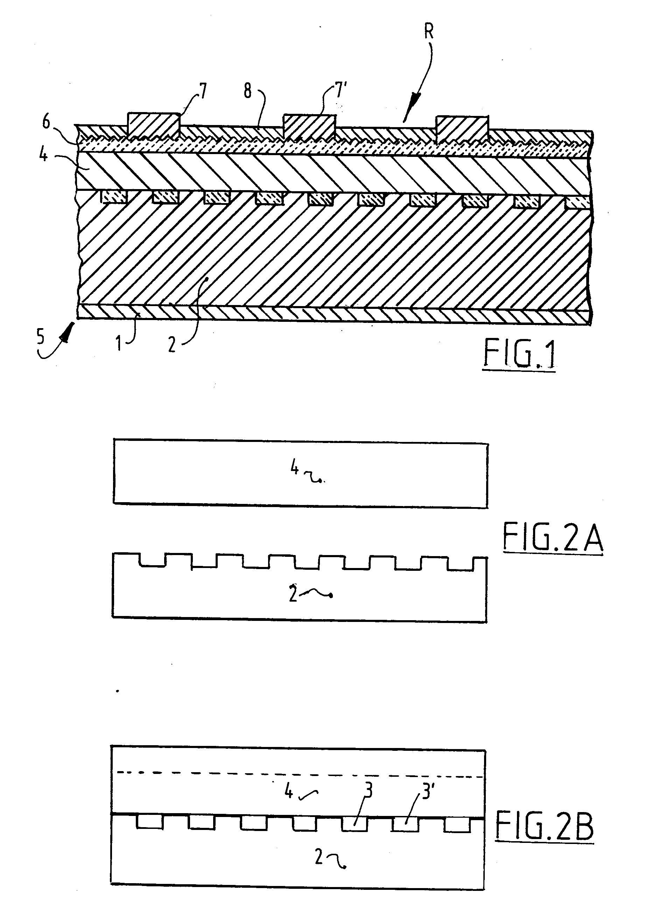

In the manufacture of the shown preferred embodiment of the present invention (fig. 2A) the part 4 from fig. 1 is bonded directly onto the part 2 of fig. 1, wherein oxidation of both parts has to be prevented. Hereby, cavities 3, 3' with air inclusions are formed herein whereby a large difference in the index of refraction at least partially results between the converting layer 4 and the substrate 2.

The converting layer 4 is subsequently thinned down to the required thickness for the converting layer 4, for instance 50 µm and the contacts 7, 7', the passivating layer 6 and the anti-reflective layer 8 are arranged thereon in known manner.

It is expected that with the preferred embodiment shown a considerable improvement in output, for example up to 20%, can be obtained from such solar cells, preferably of silicon.

Modifications in respect of the shown described embodiment should be apparent; for instance, the technique shown will also be applicable to GaAs solar cells.

## Claims

1. A method for producing a semiconductor element (5) for converting incident light into charge carriers, comprising the steps of:
- providing a semiconducting substrate (2) with hollows;
- providing a converting part (4) of semiconductor material for converting incident light into charge carriers; and
- bonding the substrate and the converting part together, such that cavities (3,3') with air inclusions are formed.

2. A method according to claim 1, wherein the converting part of semiconductor material is subsequently thinned down to the required thickness to serve as a converting layer for converting incident light into charge carriers.

3. An element (5) of semiconductor material, comprising:
- a substrate (2) of doped semiconductor material;
- a converting layer (4) for converting incident light into charge carriers; and
- a reflecting interface between the substrate and said converting layer; **characterized in that**
- the interface comprises cavities (3,3') with air inclusions whereby a large difference in the index of refraction between the converting layer (4) and the substrate (2) results.

## Patentansprüche

1. Verfahren zur Herstellung eines Halbleiterelements (5) zur Umwandlung von auffallendem Licht in Ladungsträger, mit den Schritten:
- Herstellen eines Halbleitersubstrats (2) mit Hohlräumen;
- Herstellen eines Umwandlungsteils (4) aus Halbleitermaterial zur Umwandlung von auffallendem Licht in Ladungsträger; und
- gegenseitiges Verbinden des Substrats und des Umwandlungsteils derart, daß die Hohlräume (3, 3') mit Lufteinschlüssen ausgebildet werden.

2. Verfahren nach Anspruch 1, bei dem das Umwandlungsteil aus Halbleitermaterial anschließend auf die erforderliche Dicke dünner ausgebildet wird, um als eine Umwandlungsschicht zum Umwandeln von auffallendem Licht in Ladungsträger zu dienen.

3. Element (5) aus Halbleitermaterial, mit:
- einem Substrat (2) aus dotiertem Halbleitermaterial;
- einer Umwandlungsschicht (4) zur Umwandlung von auffallendem Licht in Leitungsträger, und
- einer reflektierenden Zwischenfläche zwischen dem Substrat und der Umwandlungsschicht; **dadurch gekennzeichnet**, daß
- die Zwischenfläche Hohlräume (3, 3') mit Lufteinschlüssen aufweist, wodurch sich eine große Differenz zwischen dem Brechungsindex der Umwandlungsschicht (4) und dem Brechungsindex des Substrats (2) ergibt.

## Revendications

1. Procédé pour fabriquer un élément semi-conducteur (5) afin de convertir la lumière incidente en porteurs de charge, comprenant les étapes suivantes :
- création d'un substrat semi-conducteur (2) avec des espaces creux ;
- création d'une portion de conversion (4) en matériau semi-conducteur pour convertir la lumière incidente en porteurs de charge : et
- collage du substrat et de la portion de conversion de sorte que soient formées des cavités (3, 3') avec des inclusions d'air.

2. Procédé selon la revendication 1, dans lequel la portion de conversion du matériau semi-conducteur est amincie ultérieurement ,jusqu'à l'épaisseur souhaitée afin de servir de couche de conversion pour convertir la lumière incidente en porteurs de charge.

3. Elément (5) en matériau semi-conducteur comprenant :
- un substrat (2) de matériau semi-conducteur dopé ;
- une couche de conversion (4) pour convertir la lumière incidente en porteurs de charge ; et
- une interface réfléchissante entre le substrat et ladite couche de conversion ;
caractérisé en ce que l'interface comprend des cavités (3, 3') avec des inclusions d'air, ce qui entraîne ainsi une différence importante d'indice de réfraction entre la couche de conversion (4) et le substrat (2).
